Europäisches Patentamt

European Patent Office

Office européen des brevets

(11) Veröffentlichungsnummer: **0 055 372**
**B1**

# (12) EUROPÄISCHE PATENTSCHRIFT

(45) Veröffentlichungstag der Patentschrift:
**04.09.85**

(51) Int. Cl.⁴: **C 30 B 15/20**

(21) Anmeldenummer: **81109063.8**

(22) Anmeldetag: **28.10.81**

(54) **Verfahren zur Herstellung vertikaler PN-Übergänge beim Ziehen von Siliciumbändern aus einer Siliciumschmelze.**

(30) Priorität: **29.12.80 DE 3049376**

(43) Veröffentlichungstag der Anmeldung:
**07.07.82 Patentblatt 82/27**

(45) Bekanntmachung des Hinweises auf die Patenterteilung:
**04.09.85 Patentblatt 85/36**

(84) Benannte Vertragsstaaten:
**BE DE FR GB IT NL**

(56) Entgegenhaltungen:
**DE - B - 1 023 146**
**DE - B - 1 052 571**
**DE - C - 941 743**
**FR - A - 1 225 341**
**FR - A - 1 393 063**

(73) Patentinhaber: **HELIOTRONIC Forschungs- und Entwicklungsgesellschaft für Solarzellen-Grundstoffe mbH, Johannes-Hess-Strasse 24, D-8263 Burghausen (DE)**

(72) Erfinder: **Gessert, Cord, Dr. Dipl.-Ing., Bachstrasse 12, D-8263 Burghausen (DE)**

## Beschreibung

Zur Herstellung terrestrischer Solarzellen, die mit herkömmlichen Energieträgern konkurrieren können, ist eine erhebliche Verbilligung des Grundmaterials Voraussetzung. Es wurden daher eine Reihe von Bänderziehverfahren entwickelt, bei welchen Silicium gleich in der gewünschten Dicke anfällt, um somit den zeit- und kostenintensiven Sägeschnitt – wie er bei der Herstellung von Scheiben aus Stabmaterial erforderlich ist – einzusparen.

Derartige Verfahren sind beispielsweise das EFG-Verfahren (edge defined film fed growth) und das diesem ähnliche CAST-Verfahren (capillary action shaping technique), bei welchen ein Siliciumband von der oberen Öffnung eines siliciumbefüllten Kapillarkörpers formbestimmend abgezogen wird («Low Cost Silicon for Solar Energy Conversion Applications», G.H. Schwuttke et al, IBM J. Res. Develop., Vol. 22, No. 4, July 1978).

Weitere Bänderziehverfahren sind das WEB-Verfahren, basierend auf der Membranbildung zwischen Dendriten (R.G. Seidensticker et al «Computer Modelling of Dentritic WEB Growth Processes and Characterisation of the Material», Proceedings of the Thirteenth IEEE Photovoltaic Specialists Conference, S. 358, Washington D.C., 1978), das ESP-Verfahren (Edge supported pulling), bei welchem zwei Graphitfäden im Abstand der gewünschten Bandbreite mit einer Keimplatte in die Schmelze eingetaucht und das zwischen den Graphitfäden auskristallisierende Siliciumband nachfolgend aus der Schmelze abgezogen wird («Melt Growth of Silicon Sheets by Edge Supported Pulling», T. Ciszek, ECS Springmeeting Symposium on Novel Crystallisation Technics, St. Louis, Missouri 1980, Proceedings in print), das RTR-Verfahren (Ribbon to Ribbon), bei welchem ein polykristallines Band vermittels Laser- oder Elektronenstrahlen in hoch- bis einkristallines Material umkristallisiert wird (R.W. Gurtler et al, «Potential for Improved Silicon Ribbon Growth Trough Thermal Environment Control», Proceedings of the International Photovoltaic Solar Energy Conference, S. 145, 1979, Boston, London), das Inverted Stepanow Verfahren (US-PS 41 57 273), bei welchem ein Band aus einem Schlitz in der Unterseite eines mit flüssigem Silicium gefüllten Behältnisses abgezogen wird und schliesslich das Verfahren gemäss der DE-OS 29 03 061, bei welchem ein Siliciumband längs einer gekühlten Ziehrampe von einer Siliciumschmelze abgezogen wird.

Zur Herstellung einer Solarzelle wird das nach genannten Verfahren erhaltene scheibenförmige Material, welches durch Zugabe von üblicherweise Bor zur Schmelze p-leitend anfällt, oberflächlich durch Diffusion oder Ionenimplantation mit beispielsweise Phosphor gegendotiert, wobei der Bereich hierdurch eingestellter n-Leitfähigkeit üblicherweise bis in eine Tiefe von etwa 0,1 bis 0,5 µm reicht, unter Ausbildung des pn-Übergangs zum p-leitenden überwiegenden Scheibchenmaterial. Die Unterseite einer derartigen Solarzelle wird zum Abgreifen des Stromes mit einer Beschichtung aus beispielsweise Aluminium/Gold versehen, während die metallische Kontaktierung der Oberseite ein bestimmtes Leitfingermuster aufweist, um möglichst wenig Fläche gegenüber dem Lichteinfall abzudecken, ausserdem wird die Oberseite meist zusätzlich mit einem Antireflexionsbelag zur optimalen Ausnutzung des einfallenden Lichtes versehen. Obwohl die Dicke derartiger Halbleiterplättchen meist zwischen 200 bis 400 µm schwankt, trägt nur ein Teil der einfallenden Photonen des Sonnenlichtes zur gewinnbaren elektrischen Leistung bei. Die Absorption dieser Lichtenergie ist bekanntlich von einer Elektronen/Löcher-Paarbildung in den verschiedenen Tiefenbereichen des Scheibchens begleitet. Es tragen aber nur solche Elektronen und Löcher zum elektrischen Strom bei, die in einer Zone unterhalb des pn-Überganges gebildet werden, die durch die Diffusionslänge der Ladungsträger in der Grössenordnung von etwa 50 µm begrenzt wird, so dass insbesondere durch Lichtanteile im infraroten Bereich in grösserer Tiefe des Scheibchens erzeugte Ladungsträger nicht mehr zum abgreifbaren elektrischen Strom beitragen.

Um möglichst die gesamte einfallende Strahlung nutzbar zu machen, wird beispielsweise mit der US-PS 41 55 781 ein Material mit vertikalen pn-Übergängen aufgezeigt, welches aus auf einer Substratfläche aus beispielsweise polykristallinem Silicium mit aufgewachsenen einkristallinen Halbleiterwhiskern besteht, die nachfolgend n- oder p-dotiert werden und anschliessend im oberflächennahen Bereich durch Diffusion p- oder n-gegendotiert werden. Zur Kontaktierung wird die Whiskeroberfläche anschliessend mit einem Material überzogen, welches elektrisch leitend ist, aber lichtdurchlässig. Dieses interessante, aber wohl mehr theoretische, da durch kein praktisches Ausführungsbeispiel illustrierte, Verfahren wird aber wohl kaum den Anforderungen für terrestrische Solarzellen gerecht werden, nämlich neben einem hohen Wirkungsgrad billig in der Herstellung zu sein und robust und widerstandsfähig gegenüber Witterungseinflüssen.

Solarzellen auf Basis Silicium mit vertikalen pn-Übergängen sind auch aus der US-PS 39 69 746 bekannt. Gemäss dem darin beschriebenen Verfahren werden mit einem Ätzmittel in einen Siliciumkörper parallele Schlitze geätzt, in welche nachfolgend ein Dotierstoff zur Erzeugung eines pn-Überganges durch Diffusion eingebracht wird, welcher zu gegenteiliger Leitfähigkeit als der bereits im Silicium enthaltene Dotierstoff führt. Deck- und Bodenfläche dieses Siliciumkörpers werden nachfolgend in üblicher Weise mit Kontakten versehen. Ein derartiges Verfahren ist aber nicht nur sehr zeit- und arbeitsintensiv, sondern auch kostspielig, so dass es sich vernünftig nur für Konzentrationsanlagen einsetzen lässt, bei welchen das Sonnenlicht beispielsweise über Fresnellinsen konzentriert auf die Solarzelle fällt, wie dies beispielsweise auch für Solarzellenmaterial mit durch Ätzen oder Einsägen hergestellten vertikalen pn-Übergängen in dem Reissued-Patent 30 383 der US-PS 41 10 122 beschrieben wird. Aus der DE-B-10 52 571 ist auch ein Verfahren bekannt, beim Tiegelziehen nach Czochralski durch Variation der Kristallwachstumsgeschwindigkeit Kristallstäbe mit vertikalen pn-Übergängen herzustellen.

Der vorliegenden Erfindung lag die Aufgabe zugrunde, ein Verfahren zur Herstellung Solarzellenmaterial auf Basis Silicium mit vertikalen pn-Übergängen anzugeben, welches auf den bekannten Bänderziehverfahren aufbaut und mit möglichst wenigen separat auszuführenden Bearbeitungsschritten zu kostengünstigen Solarzellen für die breite terrestrische Anwendung führt.

Gelöst wird diese Aufgabe durch ein Verfahren, welches dadurch gekennzeichnet ist, dass der Siliciumschmelze sowohl Dotierstoffe, die als Akzeptoren, als auch solche, die als Donatoren im Siliciumkristall wirken, zugesetzt werden, deren bei hoher Kristallwachstumsgeschwindigkeit $v_h$ wirksame Verteilungskoeffizienten $k_{Aeff}(v_h)$ und $k_{Deff}(v_h)$ sowie der bei niedriger Kristallwachstumsgeschwindigkeit $v_n$ wirksame Verteilungskoeffizienten $k_{Aeff}(v_n)$ und $k_{Deff}(v_n)$ der Bedingung genügen müssen

$$\frac{k_{Aeff}(v_n) \cdot k_{Deff}(v_h)}{k_{Aeff}(v_h) \cdot k_{Deff}(v_n)} > 3 \text{ oder } < 0.3$$

wobei allgemein $v_h$ eine gegenüber der mittleren Ziehgeschwindigkeit höhere Kristallwachstumsgeschwindigkeit ist und $v_n$ eine gegenüber der mittleren Ziehgeschwindigkeit niedrigere Kristallwachstumsgeschwindigkeit ist und das Kristallwachstum während des Bänderziehens in dem Masse periodischen Änderungen von niedriger $v_n$ zu hohher $v_h$ Geschwindigkeit unterworfen wird, dass im auskristallisierten Siliciumband eine Gesamtlänge von jeweils p- und n-leitender Zone von 5 bis 2000 µm resultiert.

Die mittlere Ziehgeschwindigkeit ($v_m$) beim Bänderziehen liegt in der Grössenordnung von 6 bis 120 mm/min. Eine demgegenüber niedrige Kristallwachstumsgeschwindigkeit $v_n$ liegt mindestens 6 mm/min unterhalb der jeweils eingestellten mittleren Ziehgeschwindigkeit und eine hohe Kristallwachstumsgeschwindigkeit $v_h$ mindestens 6 mm/min. darüber, um obiger Bedingung hinsichtlich des wirksamen Verteilungskoeffizienten genügen zu können.

Als erste Abschätzung geeigneter Dotierstoffpaare genügen die in der Literatur angegebenen und in der nachstehenden Tabelle 1 beispielhaft für einige Dotierstoffpaare aufgeführten Verteilungskoeffizienten im Silicium, die sich im thermischen Gleichgewicht auf jeden Fall um mehr als eine Zehnerpotenz unterscheiden sollten.

Tabelle 1

Einsetzbare Dotierstoffpaare für Siliciumschmelzen, aus denen Bänder mit vertikalen pn-Übergängen gezogen werden können.

| Dotierstoffpaar | $k_D$ | $k_A$ |
|---|---|---|
| Sb/B | 0,023 | 0,8 |
| P/Al | 0,35 | 0,002 |
| As/Al | 0,35 | 0,002 |
| P/Ga | 0,35 | 0,008 |
| As/Ga | 0,3 | 0,008 |
| P/In | 0,35 | $4 \cdot 10_{-4}$ |
| As/In | 0,3 | $4 \cdot 10_{-4}$ |
| P,As/Ga,In | 0,35 | 0,008 |
|  | 0,3 | $4 \cdot 10^{-4}$ |

Für das Bänderziehen gemäss der Erfindung sind aber letztlich die von der Kristallwachstumsgeschwindigkeit abhängigen Verteilungskoeffizienten massgeblich, die sich in brauchbarer Genauigkeit nach folgender Gleichung abschätzen lassen

$$k_{eff}(v) = \frac{k}{k + (1-k)\exp(-v/v_D)} \qquad (1)$$

In dieser Gleichung bedeuten v die Kristallwachstumsgeschwindigkeit, k den Verteilungskoeffizienten im thermischen Gleichgewicht, also $k_A$ oder $k_D$, $k_{eff}(v)$ den effektiven Verteilungskoeffizienten bei der Kristallwachstumsgeschwindigkeit v, als $k_{Aeff}(v)$ oder $k_{Deff}(v)$ und $v_D$ die Diffusionsgeschwindigkeit, die sich aus dem Quotienten aus Diffusionskoeffizient D und Diffusionslänge L des betrachteten Dotierelementes in der Schmelze ergibt.

In der Tabelle 2 werden die effektiven Verteilungskoeffizienten für einzelne Kristallwachstumsgeschwindigkeiten (wahlweise in der SI-Einheit cm/s oder in der beim Ziehen gebräuchlichen Einheit mm/min) angegeben, wie sie sich nach obiger Gleichung (1) für die Elemente Antimon, Bor, Phosphor, Aluminium, Arsen, Gallium und Indium näherungsweise bestimmen lassen.

Wie das Kristallwachstum während des Ziehens periodischen Änderungen von niedriger zu hoher Geschwindigkeit unterworfen ist, so ändert sich auch das Verhältnis der effektiven Verteilungskoeffizienten periodisch. In Abhängigkeit der Konzentration $C_A$ und $C_D$ der der Schmelze zugesetzten Akzeptoren und Donatoren entstehen mit der Änderung der effektiven Verteilungskoeffizienten unter folgenden Bedingungen drei Bereiche:

Eine positiv leitende Zone (p-Silicium) entsteht während des Ziehvorganges für

$$\sum_{i=1}^{n} C_{iA} \cdot k_{iAeff}(v) - \sum_{j=1}^{m} C_{jD} \cdot k_{jDeff}(v) > 0 \qquad (2)$$

sofern n (ganze Zahl) Akzeptorenelemente und m (ganze Zahl) Donatorenelemente das Dotierstoffpaar in der Schmelze bilden. Für ein Dotierstoffpaar, das aus je einem Donatorenelement und einem Akzeptorelement besteht, vereinfacht sich obige Gleichung zu

$$\left( k_{Aeff}(v) \, / \, k_{Deff}(v) \right) \cdot C_A - C_D > 0 \qquad (3)$$

Eine Raumladungszone (vertikaler pn-Übergang) bildet sich während des Ziehvorganges unter der Bedingung

$$\sum_{i=1}^{n} C_{iA} \cdot k_{iDeff}(v) - \sum_{j=1}^{m} C_{jD} \cdot k_{jDeff}(v) = 0 \qquad (4)$$

Tabelle 2

Kristallwachstumsgeschwindigkeiten und zugehörige effektive Verteilungskoeffizienten sowie Verteilungskoeffizienten im thermischen Gleichgewicht und Diffusionsgeschwindigkeiten

| V | $\frac{mm}{min}$ | 3 | 6 | 12 | 24 | 30 | 45 | 60 | 90 | 120 | k | $v_D$ |
|---|---|---|---|---|---|---|---|---|---|---|---|---|
| | $\frac{cm}{s}$ | 0,005 | 0,01 | 0,02 | 0,04 | 0,05 | 0,075 | 0,01 | 0,15 | 0,2 | | $\frac{cm}{s}$ |
| $k_{Deff}$ Sb | | 0,097 | 0,33 | 0,91 | 1 | 1 | 1 | 1 | 1 | 1 | 0,023 | 0,003 |
| $k_{Aeff}$ B | | 0,91 | 0,97 | 0,98 | 1 | 1 | 1 | 1 | 1 | 1 | 0,8 | 0,005 |
| $k_{Deff}$ p | | 0,51 | 0,68 | 0,90 | 0,99 | 1 | 1 | 1 | 1 | 1 | 0,35 | 0,007 |
| $k_{Aeff}$ In | | 0,0006 | 0,001 | 0,002 | 0,017 | 0,042 | 0,31 | 0,83 | 0,98 | 1 | 0,0004 | 0,01 |
| $k_{Deff}$ As | | 0,56 | 0,8 | 0,97 | 1 | 1 | 1 | 1 | 1 | 1 | 0,3 | 0,0045 |
| $k_{Aeff}$ Ga | | 0,017 | 0,036 | 0,15 | 0,80 | 0,94 | 1 | 1 | 1 | 1 | 0,008 | 0,0065 |
| $k_{Aeff}$ Al | | 0,0032 | 0,005 | 0,014 | 0,099 | 0,23 | 0,78 | 0,98 | 1 | 1 | 0,002 | 0,01 |

und vereinfacht sich entsprechend für ein Dotierstoffpaar, welches aus je einem Donatorelement und einem Akzeptorelement besteht, zu

$$\left( k_{Aeff}(v) \, / \, k_{Deff}(v) \right) \cdot C_A - C_D = 0 \qquad (5)$$

Eine negativ leitende Zone (n-Silicium) entsteht dagegen unter der Bedingung

$$\sum_{i=1}^{n} C_{iA} \cdot k_{iAeff}(v) - \sum_{j=1}^{m} C_{jD} \cdot k_{jDeff}(v) < 0 \qquad (6)$$

Für $m = n = 1$ vereinfacht sich die Gleichung wieder entsprechend zu

$$\left( k_{Aeff}(v) \, / \, k_{Deff}(v) \right) \cdot C_A - C_D < 0 \qquad (7)$$

Die periodische Änderung von niedriger zu hoher Wachstumsgeschwindigkeit lässt sich dabei beispielsweise durch eine periodische Änderung der Ziehgeschwindigkeit oder allgemein durch eine periodische Änderung der Temperatur der Schmelze im Bereich der Wachstumsfront einstellen. Letzteres kann beispielsweise durch periodisches Ein- und Abschalten von Zusatzkühlungen, periodisches Vergrössern und Verkleinern des Kühlmittelflusses, periodisches Ein- und Abschalten von Zusatzheizungen, periodisches Vergrössern und Verkleinern der Leistung von Zusatzheizungen und Hauptheizung, periodisches Zu- und Abschalten, Vergrössern und Verringern oder Umpolen eines Gleichstromflusses durch die Grenzschicht zwischen aufwachsendem Kristall und Schmelze, periodisches Zu- und Abschalten eines Stromstosses, periodisches Öffnen und Schliessen einer Strahlungsabschirmung etc. realisiert werden.

Die vorstehend beispielhaft beschriebenen Massnahmen können dabei beispielsweise einer periodischen Rechteckfunktion, einer periodischen Rampenfunktion, einer periodischen Trapezfunktion, einer periodischen Dreiecksfunktion, einer periodischen Impulsfunktion oder einer periodischen Winkelfunktion folgen. Die Wirkung dieser Massnahmen auf die Periodizität der Änderung der Wachstumsgeschwindigkeit wird dabei aufgrund systemimmanenten Trägheit natürlich nicht die Ecken einer Rechteckfunktion etc. aufweisen, sondern mehr einer Winkelfunktion gleichen. Am einfachsten und in der Regel zutreffendsten lässt sich daher der periodische Verlauf an einer Sinusfunktion verdeutlichen

$$v = v_m + v_a \sin 2\pi f_w \cdot t \qquad (8)$$

Es bedeuten dabei v wieder die zeitvariable Kristallwachstumsgeschwindigkeit, $v_m$ die Ziehgeschwindigkeit, $v_a$ die maximale Änderung der Kristallwachstumsgeschwindigkeit (maximale Amplitude), t die Zeit und $f_w$ die Frequenz der Änderung.

Die Frequenz ergibt sich dabei aus dem Quotienten von Ziehgeschwindigkeit und der gewünschten Länge 1 der positiven und negativen

Zone $(1 = 1_p + 1_n)$, die anspruchsgemäss zwischen 5 und 2000 µm liegt.

Bei einer Ziehgeschwindigkeit von $v_m = 0,05$ cm/sec ergäbe sich bei einer gewünschten Gesamtlänge 1 von positiv und negativ leitender Zone von 100 µm somit eine erforderliche Variationsfrequenz über das Kristallwachstum von 5 Hz oder $5\,s^{-1}$.

Für die spezielle Anwendung des erfindungsgemässen Verfahrens auf die Herstellung von Solarzellengrundmaterial muss die Gesamtlänge 1 von positiver und negativ leitender Zone im Bereich von

$$0,05\,L_d < 1 < 2\,L_d \qquad (9)$$

liegen – wobei $L_d$ die Diffusionslänge der Minoritätsladungsträger im Silicium für Solarzellen bedeutet – um einen höheren Wirkungsgrad als bei herkömmlichen Solarzellen aus gleichem Grundmaterial, aber mit horizontalem pn-Übergang, zu erzielen.

Im folgenden wird die Erfindung beispielhaft anhand von Graphen und schematischen Darstellungen der nach dem Verfahren herstellbaren Solarzelle bzw. apparativer Details weiter erläutert:

Figur 1: Graphische Darstellung der Entstehung von pn-Übergängen während des Kristallwachstums bei Zugabe des Dotierstoffpaares Bor/Antimon zur Siliciumschmelze

Figur 2: Graphische Darstellung der Entstehung von pn-Übergängen während des Kristallwachstums bei Zugabe des Dotierstoffpaares Phosphor/Gallium zur Siliciumschmelze

Figur 3: Graphische Darstellung der Entstehung von pn-Übergängen während des Kristallwachstums bei Zugabe des Dotierstoffpaares Phosphor/Indium zur Siliciumschmelze

Figur 4: Schematischer Aufbau einer Anlage zum diskontinuierlichen Ziehen von Siliciumbändern mit vertikalen pn-Übergängen

Figur 5: Schematischer Aufbau einer Anlage zum kontinuierlichen Ziehen von Siliciumbändern mit vertikalen pn-Übergängen

Figur 6: Anordnung von Kühlkörpern im Bereich der Wachstumsfront in der Seitenansicht

Figur 7: Anordnung von Kühlgasdüsen im Bereich der Wachstumsfront in der Seitenansicht

Figur 8: Anordnung von Kühlgasdüsen im Bereich der Wachstumsfront in der Aufsicht

Figur 9: Anordnung von Lichtleitern im Bereich der Wachstumfront in der Seitenansicht

Figur 10: Anordnung von Lichtleitern im Bereich der Wachstumsfront in der Aufsicht

Figur 11: Zusatzheizung im Bereich der Wachstumsfront vermittels Laser in der Seitenansicht

Figur 12: Zusatzheizung im Bereich der Wachstumsfront vermittels Laser in der Aufsicht

Figur 13: Zusatzheizung über Graphitfäden

Figur 14: Zusatzheizung über Hochfrequenzgenerator

Figur 15: Anordnung zur Beeinflussung der Kristallwachstumsgeschwindigkeit vermittels Stromimpulsen

Figur 16: Anordnung zur Beeinflussung der Kristallwachstumsgeschwindigkeit mit einer Strahlungsabschirmung

Figur 17: Dreiseitenansicht einer Solarzelle mit gezogenen, vertikalen pn-Übergängen

Figur 18: Prinzipskizze der Herstellung vertikaler pn-Übergänge beim Ziehen von Siliciumbändern.

Zur Erläuterung der in Anspruch 1 angegebenen Bedingung bezüglich der wirksamen Verteilungskoeffizienten

$$\frac{k_{Aeff}(v_n) \cdot k_{Deff}(v_h)}{k_{Aeff}(v_h) \cdot k_{Deff}(v_n)} > 3 \text{ oder } < 0.3$$

vorzugsweise $\dfrac{k_{Aeff}(v_n) \cdot k_{Deff}(v_h)}{k_{Aeff}(v_h) \cdot k_{Deff}(v_n)} > 10 \text{ oder } < 0.1$

wird in der Tabelle 3 das Auftreten von pn-Übergängen unter Vernachlässigung sonstiger Parameter beispielhaft für drei Dotierstoffpaare für verschiedene Kristallwachstumsgeschwindigkeiten $v_n$ und $v_h$ angegeben, die periodisch um eine mittlere Ziehgeschwindigkeit von 30 mm/min variieren.

Tabelle 3

Abhängigkeit des Auftretens von pn-Übergängen von den wirksamen Verteilungskoeffizienten der eingesetzten Dotierstoffpaare

| Dotierstoffpaar | $v_n/v_h$ | $\dfrac{k_{Aeff}(v_n) \cdot k_{Deff}(v_h)}{k_{Aeff}(v_n) \cdot k_{Deff}(v_n)}$ | | pn-Übergänge |
|---|---|---|---|---|
| B/Sb | 24/36 | $\dfrac{1 \cdot 1}{1 \cdot 1}$ | = 1,000 | nein |
| | 12/46 | $\dfrac{0,98 \cdot 1}{1 \cdot 0,91}$ | = 1,077 | nein |
| | 6/54 | $\dfrac{0,97 \cdot 1}{0,33 \cdot 1}$ | = 2,94 | nein |
| | 3/57 | $\dfrac{0,91 \cdot 1}{0,091 \cdot 1}$ | = 10 | ja |
| P/Ga | 23/36 | $\dfrac{0,80 \cdot 1}{1 \cdot 0,99}$ | = 0,8 | nein |
| | 12/46 | $\dfrac{0,15 \cdot 1}{1 \cdot 0,9}$ | = 0,16 | ja |
| | 6/54 | $\dfrac{0,036 \cdot 1}{1 \cdot 0,68}$ | = 0,053 | ja |
| | 3/57 | $\dfrac{0,097 \cdot 1}{1 \cdot 0,51}$ | = 0,033 | ja |
| P/In | 24/36 | $\dfrac{0,017 \cdot 1}{0,12 \cdot 0,99}$ | = 0,14 | ja |
| | 12/46 | $\dfrac{0,002 \cdot 1}{0,31 \cdot 0,9}$ | = 0,007 | ja |
| | 6/54 | $\dfrac{0,001 \cdot 1}{0,5 \cdot 0,58}$ | = 0,003 | ja |
| | 3/57 | $\dfrac{0,0006 \cdot 1}{0,8 \cdot 0,51}$ | = 0,0015 | ja |

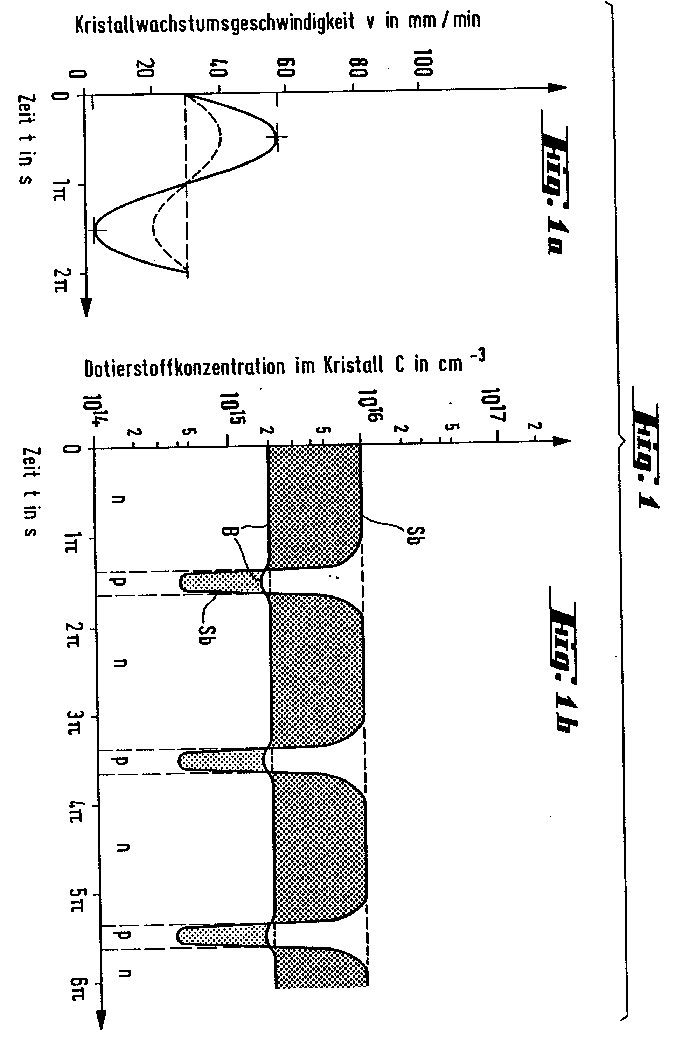

Nachdem die Bildung von pn-Übergängen im Silicium nicht nur von der Frequenz und der Amplitude der Variation der Kristallwachstumsgeschwindigkeit bzw. der die Kristallwachstumsgeschwindigkeit beeinflussenden Massnahmen abhängt, sondern auch – wie gezeigt werden konnte – von den Konzentrationen der Akzeptoren und Donatoren, $C_{iA}$ und $C_{iD}$ in der Schmelze werden im folgenden anhand der Figuren 1 bis 3 beispielshafte Konzentrationen für drei Dotierstoffpaare und die sich daraus ergebenden Folgen von pn-Übergängen diskutiert. In den graphischen Darstellungen ist links die Amplitude der Variation der Kristallwachstumsgeschwindigkeit für 27 mm/min und für 10 mm/min bei einer mittleren Ziehgeschwindigkeit von 30 mm/min gegen die Zeit angegeben. Im rechten Teil dieser Graphen wird die für die unterschiedlichen Dotierstoffpaare hieraus resultierende Dotierstoffkonzentration entsprechend Gleichungen 1, 3, 7 und 8 im auskristallisierten Siliciumband wiederum gegen die Zeit dargestellt.

Für das Dotierstoffpaar Bor/Antimon ergibt sich bei einer Zugabe von $10^{16}$ Atomen Antimon und $2 \cdot 10^{15}$ Atomen Bor pro cm³ Siliciumschmelze bei einer Variation der Kristallwachstumsgeschwindigkeit von

$$v = 30 \text{ mm/min} + 27 \text{ mm/min} \cdot \sin 2\pi f_w \cdot t$$

ein periodischer Wechsel von positiv (p) und negativ (n) leitenden Zonen im Silicium entsprechend den durchgezogenen Linien der Figur 1, wie sich dies näherungsweise auch bereits aus Tabelle 2 entnehmen lässt: die effektiven Verteilungskoeffizienten von Antimon und Bor weichen praktisch erst beim Unterschreiten der Kristallwachstumsgeschwindigkeit unter den Wert von 24 mm/min von 1 ab, d.h. erst beim weiteren Absinken auf ca. 5 mm/min kommt es zur Kompensation des in der Schmelze gegenüber Bor überschüssigen Antimons unter Ausbildung des pn-Überganges und nachfolgend zu p-leitendem Silicium, da dann trotz des Überschusses von Antimon in der Schmelze mehr Bor eingebaut wird, bis die Kristallwachstumsgeschwindigkeit wieder über den Kompensationspunkt bei einer Kristallisationsgeschwindigkeit, die allerdings immer noch kleiner als 24 mm/min ist (genauer Wert aus Gleichung 1 bestimmbar!), angestiegen ist.

Beträgt die Variation der Kristallwachstumsgeschwindigkeit bei sonst gleichen Verhältnissen dagegen nur

$$v = 30 \text{ mm/min} + 10 \text{ mm/min} \cdot \sin 2\pi f_w \cdot t$$

so ergeben sich keine pn-Übergänge im Kristall entsprechend der gestrichelten Linie in der Figur 1, da die Ziehgeschwindigkeit nur auf einen Wert von minimal 20 mm/min abfällt, bei welcher der effektive Verteilungskoeffizient von Antimon wie Bor noch unverändert etwa 1 beträgt.

Betrachtet man das Dotierstoffpaar Gallium/Phosphor, so ergibt sich bei einer Zugabe von $10^{16}$ Galliumatomen und $2 \cdot 10^{15}$ Phosphoratomen auf einen cm³ Silicium bei einer Variation der Kristallgeschwindigkeit von

$$v = 30 \text{ mm/min} + 27 \text{ mm/min} \cdot \sin 2\pi f_w \cdot t$$

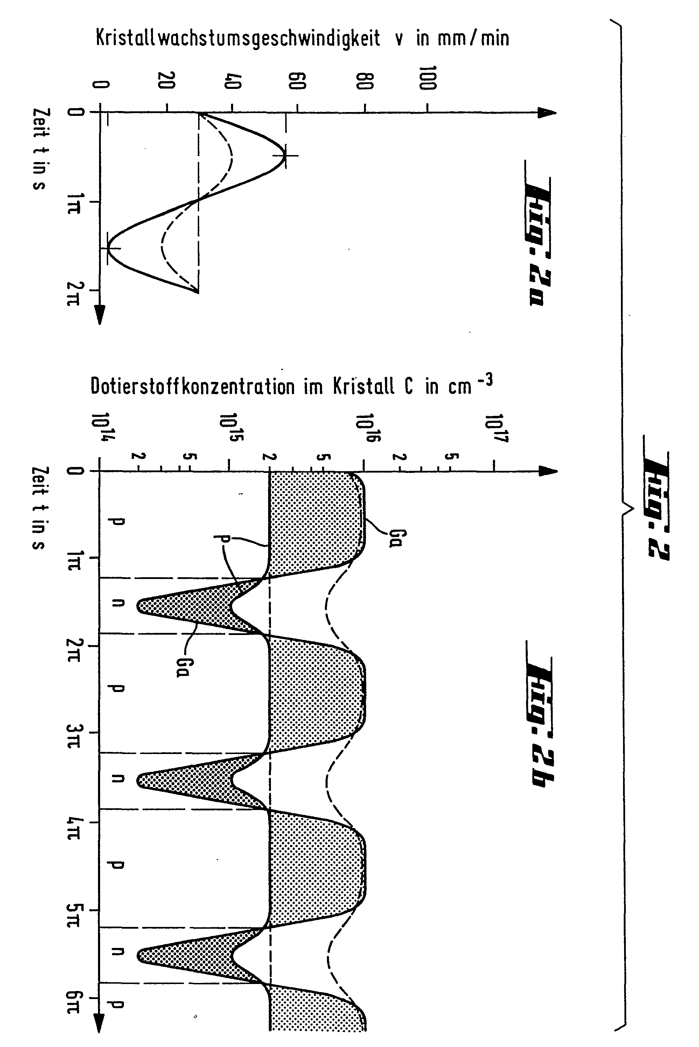

eine Folge von pn-Übergängen im auskristallisierten Silicium entsprechend den durchgezogenen Linien in Figur 2.

Beträgt die Variation der Kristallwachstumsgeschwindigkeit bei sonst wiederum gleichen Verhältnissen dagegen nur

$$v = 30 \text{ mm/min} + 10 \text{ mm/min} \cdot \sin 2\pi f_w \cdot t$$

so ergeben sich keine pn-Übergänge. Wohl ändern sich bei diesem Dotierstoffpaar bereits beim Unterschreiten der Kristallwachstumsgeschwindigkeit unter einen Wert von 30 mm/min die effektiven Verteilungskoeffizienten (vgl. Tabelle 2), jedoch ist die Abweichung zu vering, als dass der nunmehr vermehrte Phosphoreinbau den aufgrund des in der Schmelze überschüssig vorhandenen Galliums immer noch überwiegenden Galliumeinbau kompensieren oder gar überschreiten könnte. Analoges gilt beispielsweise auch für das Dotierstoffpaar Gallium/Arsen.

Geht man nun über zu dem Dotierstoffpaar Indium/Phosphor, so ergeben sich bei einer Zugaben von $2 \cdot 10^{15}$ Indiumatomen und $2 \cdot 10^{15}$ Phosphoratomen pro cm³ Siliciumschmelze sowohl bei einer Variation der Kristallwachstumsgeschwindigkeit von

$$v = 30 \text{ mm/min} + 27 \text{ mm/min} \cdot \sin 2\pi f_w \cdot t$$

als auch bei einer Variation von nur

$$v = 30 \text{ mm/min} + 10 \text{ mm/min} \cdot \sin 2\pi f_w \cdot t$$

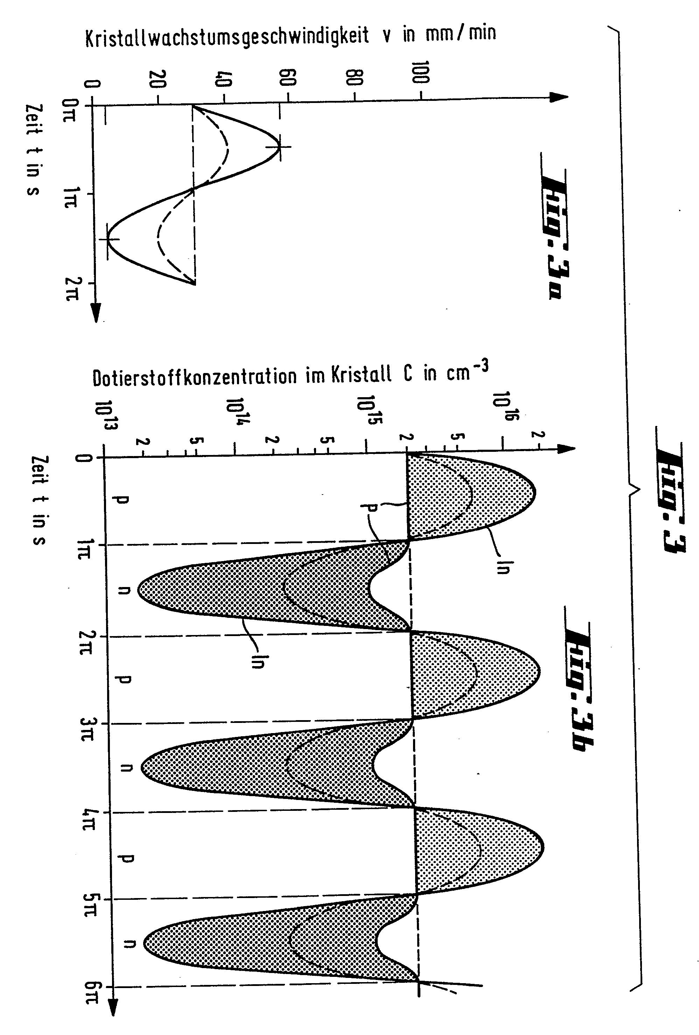

pn-Übergänge entsprechend den durchgezogenen und gestrichelten Linien in Figur 3, da sich hier die effektiven Verteilungskoeffizienten bei der Abweichung von der mittleren Ziehgeschwindigkeit und hierdurch bedingten Kristallwachstumsgeschwindigkeit von 30 mm/min sofort sehr stark ändern. Wie der Tabelle 2 zu entnehmen ist, liegen die Verhältnisse ähnlich für die Dotierstoffpaare Indium/Arsen, Aluminium/Phosphor und Aluminium/Arsen.

Nachdem für die Ausbeuten des Verfahrens eine hohe Ziehgeschwindigkeit vorteilhaft ist, setzt man zweckmässig Dotierstoffpaare ein, mit einem hinsichtlich seines effektiven Verteilungskoeffizienten stark variierenden Akzeptors bei möglichst gleichbleibendem effekttivem Verteilungskoeffizienten des zugehörigen Donators und umgekehrt. Bei dem vorstehend beschriebenen Beispiel Indium/Phosphor liessen sich demnach beispielsweise auch mit einer mittleren Ziehgeschwindigkeit von 45 mm/min und einer Variation von $v = 45 \text{ mm/min} + 15 \text{ mm/min} \cdot \sin 2\pi f_w \cdot t$ vertikale pn-Übergänge realisieren.

Sollen die Dotierstoffzugaben zur Siliciumschmelze nicht in Dotierstoffatomen pro cm³ Siliciumschmelze, sondern in Dotierstoffgewicht pro Gewicht des eingeschmolzenen Siliciums bemessen werden, so ist folgende Umrechnung vorzunehmen

$$W = \frac{C \cdot a}{N \cdot \varsigma_{Si}} \cdot W_{Si}$$

wobei W und $W_{Si}$ das Gewicht der Dotierstoffzugabe bzw. des eingeschmolzenen Siliciums bedeuten, C die Konzentration der Dotierstoffzugabe ($C_{iA}$ bzw. $C_{jD}$) a das Atomgewicht des Dotierstoffes (i, j, a), N die Avogadro'sche Zahl ($6,022045 \cdot 10^{23}$ pro Molgewicht in g) und $\varsigma_{Si}$ das spezifische Gewicht des Siliciums ($2,329$ g/cm³).

Prinzipiell lassen sich erfindungsgemäss natürlich auch Dotierstoffpaare aus mehr als zwei Komponenten einsetzen.

Nach sämtlichen Bänderziehverfahren, insbesondere nach den einleitend diskutierten, derzeit bekannten Ausführungsformen lassen sich bei Anwendung der erfindungsgemässen Lehre Siliciumscheiben mit vertikalen pn-Übergängen herstellen.

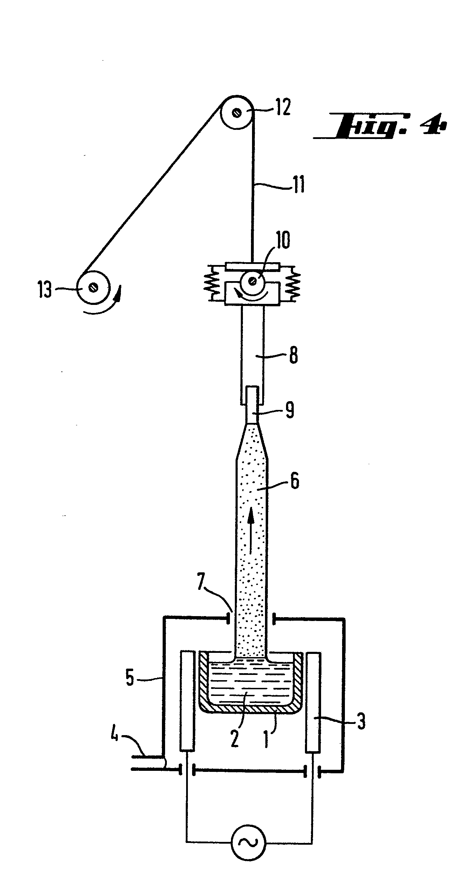

Zu diesem Zweck werden beispielsweise in einer Ziehanlage, wie sie schematisch in Figur 4 dargestellt ist, in einen Tiegel 1 aus beispielsweise Quarz, Siliciumnitrid oder mit Siliciumnitrid und/oder Siliciumcarbid beschichtetem Graphit schmelzflüssiges Silicium 2 mit dem einzusetzenden Dotierstoffpaar in den erforderlichen Konzentrationen vermischt. Der Tiegel 1 kann dabei während des Ziehens in unveränderter Position gehalten werden oder – wie aus dem Stande der Technik hinreichend bekannt – über eine Tiegelwelle dem Schmelzverbrauch entsprechend langsam nach oben gefahren werden, so dass sich die freie Schmelzoberfläche immer in der gleichen Höhe gegenüber den regelbaren Heizelementen 3 befindet, über welche die Temperatur der Siliciumschmelze 2 gesteuert wird. Der Ziehraum, insbesondere im Bereich der freien Schmelzoberfläche, wird während des Bänderziehens wie üblich mit Schutzgas durchspült, beispielsweise durch Einbringen von Argon über den Gasstutzen 4, um eine Reaktion der Siliciumschmelze 2 mit Luftsauerstoff zu vermeiden. Die schutzgasdurchströmte Abdeckung 5 von Tiegel 1 und Heizer 3 weist im oberen Teil eine von den Abmessungen des zu ziehenden Siliciumbandes 6 abhängige rechteckige Öffnung 7 auf, durch welche das Siliciumband 6 abgezogen wird, wobei das bei 4 eintretende Schutzgas durch den von der Öffnung 7 in der Abdeckung 5 und im Siliciumband 6 ausgebildeten schmalen Spalt austritt und somit das Eindringen unerwünschten Luftsauerstoffs verhindert.

Zur Erzielung vertikaler pn-Übergänge wird während des Ziehens das Siliciumband 6, welches nach dem Eintauchen der an dem Kristallhalter 8 befestigten Keimplatte 9 an dieser anwächst, periodisch durch den Exzenter 10 mit einer bestimmten Frequenz in die Schmelze eingetaucht und herausgezogen. Die mittlere Ziehgeschwindigkeit wird durch gleichmässiges Aufrollen des Stahlseiles 11 über die Umlenkrolle 12 auf die Antriebsrolle 13 erreicht.

Die Länge in einer derartigen Anlage gezogener Bänder wird im wesentlichen durch den Abstand der Keimplatte 9 bei bis zur Umlenkrolle 12 hochgezogenem Kristallhalter 8 und der Oberfläche der Siliciumschmelze 2 begrenzt.

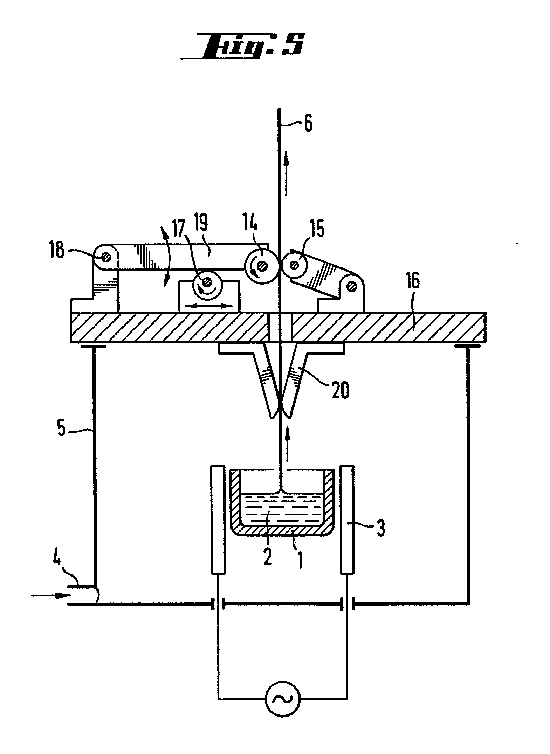

Diese Begrenzung der Bandlänge entfällt in einer Anlage, wie sie schematisch in Figur 5 dargestellt ist. Das Siliciumband 6 wird bei dieser Ausführungsform nicht mehr in endlicher Länge an einem Stahlseil aus der Schmelze 2 gezogen, sondern kontinuierlich aus der Schmelze 2 mit Hilfe der Antriebswalze 14 gefördert, an die das Siliciumband 6 mittels der Andruckrolle 15 gepresst wird. Der Beginn des Bänderziehens erfolgt dabei über eine Keimkristallplatte, die entweder lang genug ist, dass sie von der Antriebswalze 14 bis in die Siliciumschmelze 2 reicht, oder sie wird einfach an der Unterseite eines entsprechend bandförmig ausgebildeten Kristallhalters befestigt und in die Schmelze bei Beginn des Bänderziehens eingetaucht. Zur Einstellung der vertikalen pn-Übergänge befindet sich auf der verstärkten Deckplatte 16 der schutzgasdurchspülten Abdeckung 5 ein Exzenterblock 17, der seitlich verschiebbar ist, so dass sich jede gewünschte periodische Änderung des Bandhubes einstellen lässt. Die Antriebsrolle 14 ist über das Gelenk 18 schwenkbar, so dass bei gleichmässiger Drehung des Exzenters 17 eine periodische Änderung des Kristallwachstums auftritt. Der Exzenter 17 hebt mit seiner Drehung den Arm 19, an welchem die Antriebswalze 14 befestigt ist, gleichmässig ein Stück an, mit dem Ergebnis einer Erhöhung der durch die Drehung der Antriebswalze 14 vorgegebenen mittleren Ziehgeschwindigkeit und lässt aufgrund seiner Exzentrizität periodisch den Arm 19 wieder etwas absinken, entsprechend einer reduzierten Ziehgeschwindigkeit.

Da das Band freistehend aus der Schmelze gezogen wird, muss durch eine Führung 20 beispielsweise Quarz das Siliciumband ausgerichtet werden. Die Siliciumbänder können während des Ziehens stückweise in der gewünschten Länge abgetrennt werden. Der kontinuierliche Betrieb dieser Anlage ist nur durch die vorgegebene Siliciumschmelzmenge begrenzt. Die Anlage lässt sich aber auch leicht mit einem Nachfüllstutzen zum Nachchargieren von Silicium im festen oder geschmolzenen Zustand versehen, sowie zum Nachchargieren von Dotierstoffen entweder als solche oder in Form vordotierten Siliciums. Die Änderung der Kristallwachstumsgeschwindigkeit lässt sich natürlich nicht nur durch periodisches Ändern der Ziehgeschwindigkeit erreichen, sondern insbesondere durch periodische Temperaturänderung im Gebiet der Wachstumsfront.

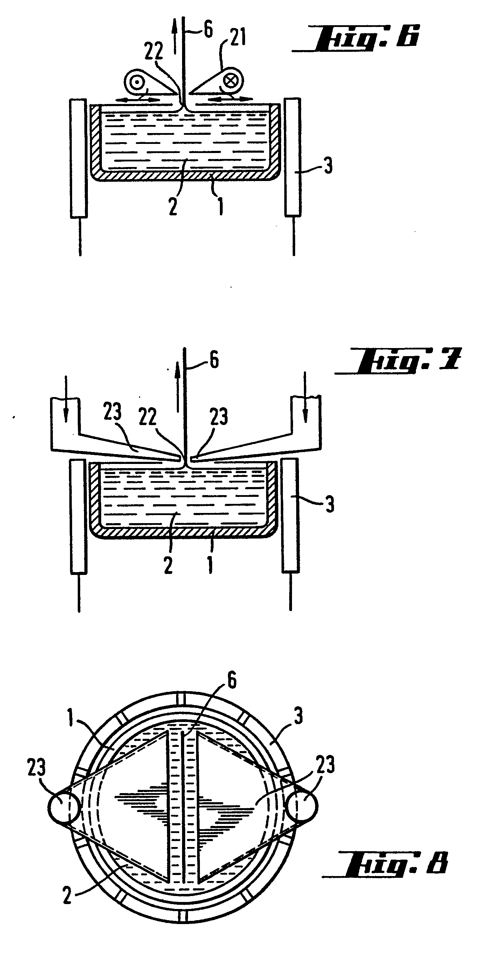

Dies lässt sich beispielsweise durch zusätzliche Kühlkörper erreichen, wie sie in Figur 6 dargestellt sind. Die Kühlplatten 21, die von einem flüssigen oder gasförmigen Kühlmedium durchflossen werden, werden so angebracht, dass sie direkt auf die Wachstumsfront 22 einwirken. Sie bewirken eine periodische Kühlung der Wachstumsfront 22, entweder durch pulsierenden Kühlmittelstrom oder durch periodische mechanische Verschiebung der Kühlkörper.

Gemäss Figur 7 und 8 wird ein Teil des Schutzgasstromes nicht kontinuierlich, sondern pulsierend, beispielsweise vermittels einer Schlauchpumpe über flache Düsen 23 der Kristallwachstumsfront 22 zugeführt, wodurch ebenfalls das Kristallwachstum in periodischem Wechsel beeinflusst wird.

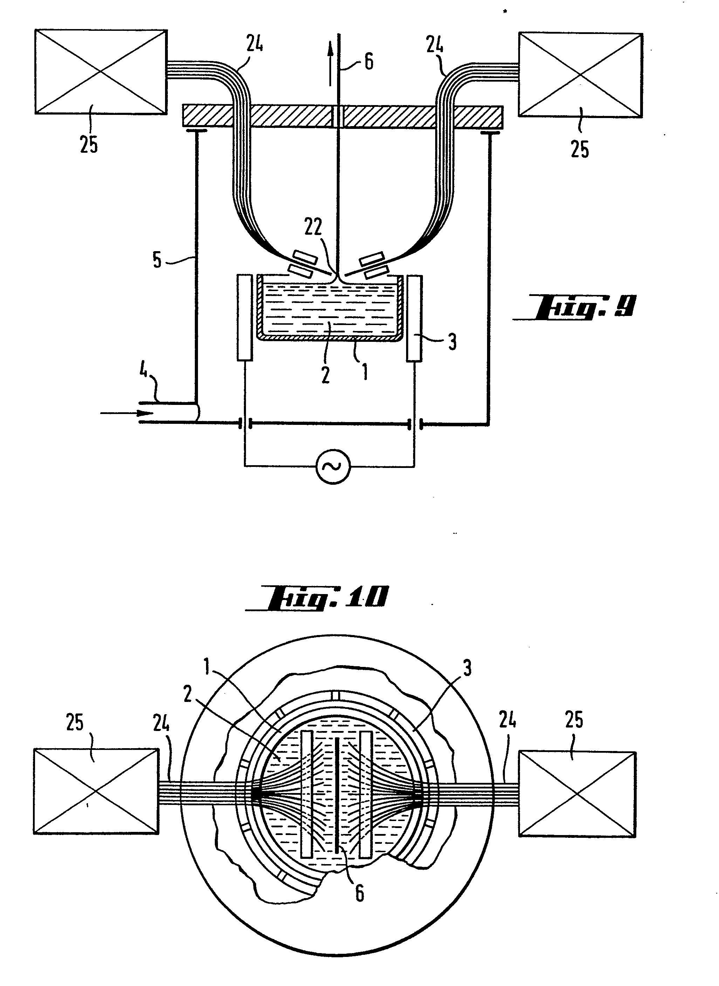

Figur 9 und 10 zeigen eine Zusatzheizung über Glasfaserbündel. Hierbei leiten die Glasfaserbündel 24 die Wärme periodischer Lichtblitze einer Lichtquelle 25 oder eines periodisch abgedunkelten Laserstrahls auf die Kristallisationsfront 22 des Siliciumbandes 6, dadurch, dass die Glasfaserbündel 24 im unteren Drittel aufgefächert werden.

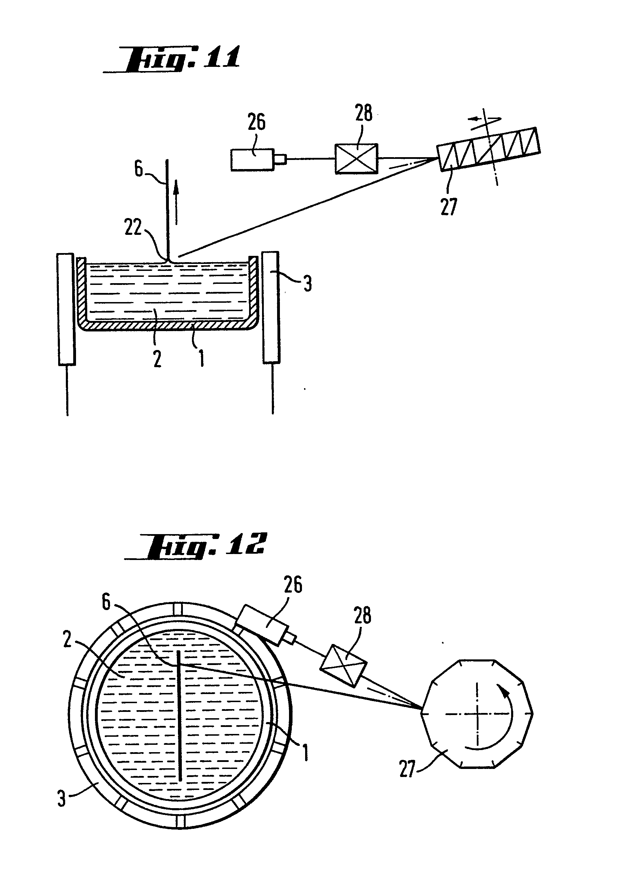

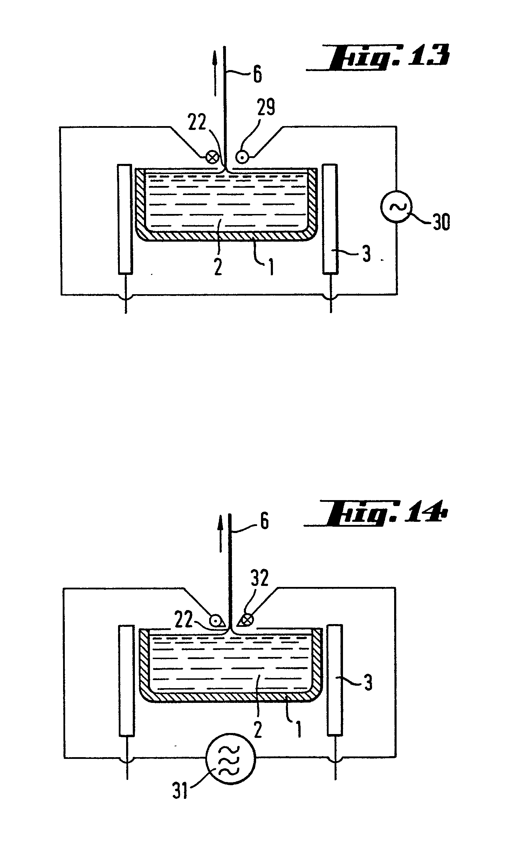

Eine Beeinflussung der Wachstumsfront lässt sich durch Laserstrahlen, aber auch dadurch erzielen, dass gemäss Figur 11 und 12 der Laserstrahl eines Lasergenerators 26 über eine rotierende Spiegelmatrix 27 so abgelenkt wird, dass er nach Fokussierung über ein Linsensystem 28 genau die Kristallisationsfront 22 des Siliciumbandes 6 bestreicht. Durch periodisches Unterbrechen des Laserstrahls lässt sich auf diese Art die Kristallwachstumsgeschwindigkeit periodisch ändern.

Eine weitere Möglichkeit der Einflussnahme auf die Kristallwachstumsgeschwindigkeit besteht in der Zusatzheizung über Graphitfäden gemäss Figur 13. Gemäss dieser Ausführungsform werden sehr dünne Graphitfäden 29 mit einem Durchmesser in der Grössenordnung von 0,3 bis 3 mm an der Kristallwachstumsfront 22 entlanggeführt und periodisch mit einer Zusatzheizung 30 zur Weissglut gebracht.

Figur 14 zeigt die Möglichkeit der Einflussnahme auf die Kristallwachstumsgeschwindigkeit mit einem Hochfrequenzgenerator 31. Ein Hochfrequenzgenerator 31 sorgt dabei für periodische induktive Aufheizung der Kristallisationsgrenze vermittels einer an der Kristallisationsfront 22 entlanggeführten Spule 32.

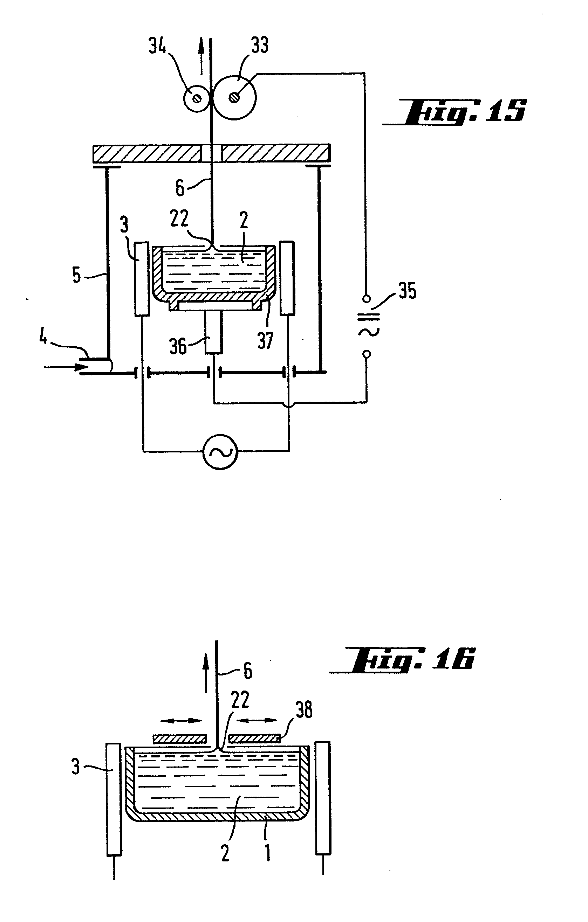

Neben den bisher beschriebenen Massnahmen lässt sich die Kristallwachstumsgeschwindigkeit aber auch nach Figur 15 vermittels Stromimpulsen durch die Kristallwachstumsfront 22 beeinflussen. Zu diesem Zweck wird eine Kontaktrolle 33 mittels einer Andruckrolle 34 an das Siliciumband 6 gepresst. Diese Kontaktrolle 33 ist an den einen Pol einer Stromquelle 35 angeschlossen. Der andere Pol der Stromquelle liegt über einem Graphitkontakt 36 am Graphittiegel 37 und damit gleichzeitig an der Siliciumschmelze 2. Durch periodische Variation des Stromflusses lassen sich auf diese Art aus dieser Schmelze ebenfalls entsprechende Siliciumbänder mit vertikalen pn-Übergängen ziehen.

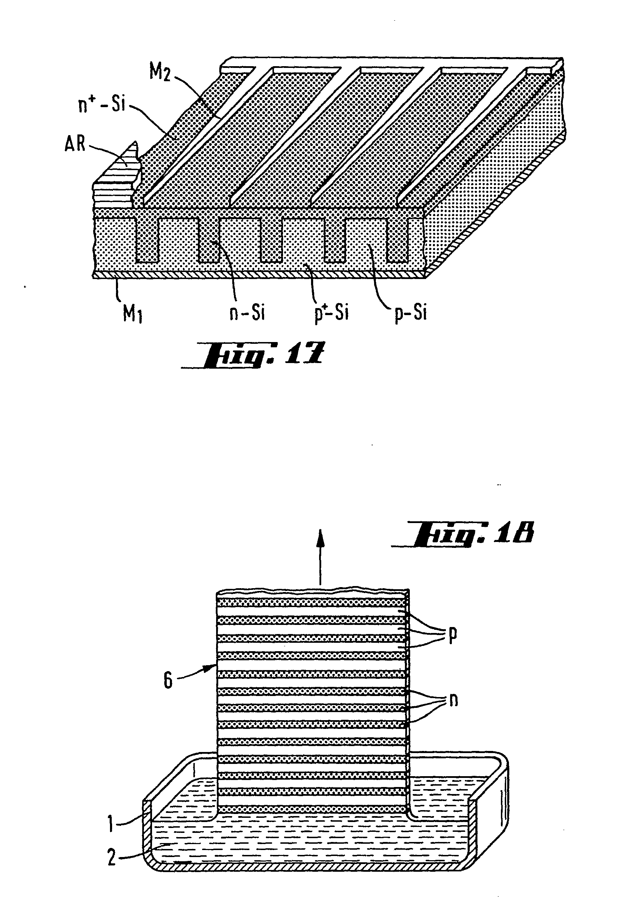

In der Figur 16 ist schliesslich noch die Beeinflussung der Kristallwachstumsfront durch Strahlungsschirme dargestellt. Zwei Abschirmplatten 38 werden so angeordnet, dass ein Spalt zwischen ihnen verbleibt. Durch diesen Spalt wird das Siliciumband 6 gezogen. Beim näherungsweisen Schliessen des Spaltes verringert sich die Kristallwachstumsgeschwindigkeit und beim Öffnen desselben erhöht sie sich, wodurch vertikale pn-Übergänge im auskristallisierten Siliciumband 6 entstehen.

Die nach dem erfindungsgemässen Verfahren hergestellten Siliciumscheiben mit vertikalen pn-Übergängen werden zur Herstellung einer Solarzelle an einer Seite in üblicher Weise noch mit einer $n^+$-Schicht durch Eindiffusion von Donatoren und an der Gegenseite durch Eindiffusion von Akzeptoren mit einer $p^+$-Schicht versehen. Nachfolgend folgt zur Kontaktierung die übliche Rückseitenmetallisierung ($M_1$) und die Aufbringung eines Metallgitters ($M_2$) auf der lichtzugewandten Seite, sowie die Beschichtung mit einer Antireflexionsschicht (AR). Eine resultierende Solarzelle aus einer Siliciumscheibe mit gezogenen vertikalen pn-Übergängen ist in Figur 17 dargestellt.

Beispiel 1

In einer Anlage, wie sie schematisch in Figur 1 dargestellt ist, wird eine Siliciumschmelze, enthaltend 9 µg Bor und 300 µg Antimon, vorgelegt. Aus dieser Schmelze wird ein Siliciumband mit den Abmessungen 0,3 × 50 mm nach oben abgezogen. Die mittlere Ziehgeschwindigkeit beträgt 24 mm/min, während der Exzenter das Band mit einer Frequenz von 8 Hz in die Schmelze eintaucht und herauszieht. Die Länge der Siliciumbänder beträgt anlagenspezifisch maximal 1,5 m. Die Länge der p-leitenden Schicht etwa jeweils 10 µm und der n-leitenden Schicht jeweils etwa 40 µm (Band liegt beim Anmelder vor).

Beispiel 2

In einer Anlage gemäss Figur 2 werden 233 g Silicium aus 2,5 Ωcm phosphordotiertem n-Silicium eingesetzt und zusammen mit 2 Indiumronden zu je 0,574 mg Gewicht eingeschmolzen. Die periodische Änderung der Kristallwachstumsgeschwindigkeit wird durch gleichmässige Drehung des Exzenters mit 480 U/min eingestellt. Der Exzenterhub beträgt 50 µm. Es werden Siliciumbänder mit den Abmessungen 0,3 × 50 mm gezogen, wobei die Längen der positiv-leitenden (p) und negativleitenden (n) Schichten jeweils 25 µm betragen, entsprechend Figur 18 (derartige Bänder liegen beim Anmelder vor.

**Patentansprüche**

1. Verfahren zur Herstellung vertikaler pn-Übergänge beim Ziehen von Siliciumbändern, aus einer Siliciumschmelze, dadurch gekennzeichnet, dass der Siliciumschmelze sowohl Dotierstoffe, die als Akzeptoren, als auch solche, die als Donatoren im Siliciumkristall wirken, zugesetzt werden, deren bei hoher Kristallwachstumsgeschwindigkeit $v_h$ wirksame Verteilungskoeffizienten $k_{Aeff}(v_h)$ und $k_{Deff}(v_h)$ sowie der bei niedriger Kristallwachstumsgeschwindigkeit $v_n$ wirksame Ver-

teilungskoeffizienten $k_{Aeff}(v_n)$ und $k_{Deff}(v_n)$ der Bedingung genügen müssen

$$\frac{k_{Aeff}(v_n) \cdot k_{Deff}(v_h)}{k_{Aeff}(v_h) \cdot k_{Deff}(v_n)} > 3 \text{ oder } < 0.3$$

wobei eine mittlere Ziehgeschwindigkeit $(v_m)$ von 6 bis 120 mm/min eingehalten wird und allgemein $v_h$ eine gegenüber der mittleren Ziehgeschwindigkeit höhere Kristallwachstumsgeschwindigkeit ist und $v_n$ eine gegenüber der mittleren Ziehgeschwindigkeit niedrigere Kristallwachstumsgeschwindigkeit ist und das Kristallwachstum während des Bänderziehens in dem Masse periodischen Änderungen von niedriger $v_n$ zu hoher $v_h$ Geschwindigkeit unterworfen wird, dass im auskristallisierten Siliciumband eine Gesamtlänge von jeweils p- und n-leitender Zone von 5 bis 2000 µm resultiert.

2. Verfahren nach Anspruch 1, dadurch gekennzeichnet, dass als Dotierstoffpaare solche ausgewählt werden, die eine hohe durchschnittliche Ziehgeschwindigkeit bei geringem Unterschied von $v_n$ und $v_h$ zulassen.

3. Verfahren nach Anspruch 1 und 2, dadurch gekennzeichnet, dass als Dotierstoffpaare Indium/Phosphor, Gallium/Phosphor oder Aluminium/Arsen eingesetzt werden.

4. Verfahren nach einem oder mehreren der Ansprüche 1 bis 3, dadurch gekennzeichnet, dass die periodische Änderung von niedriger $v_n$ zu hoher $v_h$ Wachstumsgeschwindigkeit durch eine periodische Änderung der Ziehgeschwindigkeit eingestellt wird.

5. Verfahren nach einem oder mehreren der Ansprüche 1 bis 3, dadurch gekennzeichnet, dass die periodische Änderung von niedriger $(v_n)$ zu hoher $(v_h)$ Wachstumsgeschwindigkeit durch eine periodische Änderung der Temperatur der Schmelze im Bereich der Wachstumsfront eingestellt wird.

6. Verfahren nach einem oder mehreren der Ansprüche 1 bis 5, dadurch gekennzeichnet, dass die Gesamtlänge 1 von jeweils p- und n-leitender Zone im auskristallisierten Silicium in Abhängigkeit der Diffusionslänge $L_d$ der Minoritätsladungsträger im Silicium für Solarzellen eingestellt wird entsprechend der Bedingung

$$0{,}05 \, L_d < 1 < 2 \, L_d$$

7. Verwendung des Verfahrensproduktes gemäss Anspruch 6 als Grundmaterial für Solarzellen.

## Claims

1. Process for the manufacture of vertical p-n junction in the pulling of silicon ribbons from a silicon melt, characterised in that there are added to the silicon melt both dopants that act as acceptors and dopants that act as donors in the silicon crystal, the effective distribution coefficients $k_{Aeff}(v_h)$ and $k_{Deff}(v_h)$ at a high crystal growth rate $v_h$ and the effective distribution coefficients $k_{Aeff}(v_n)$ and $k_{Deff}(v_n)$ at a low crystal growth rate $v_n$ of which dopants must satisfy the condition

$$\frac{k_{Aeff}(v_n) \cdot k_{Deff}(v_h)}{k_{Aeff}(v_h) \cdot k_{Deff}(v_n)} > 3 \text{ or } < 0.3$$

wherein a mean pulling speed $(v_m)$ of from 6 to 120 mm/min. is maintained and, generally, $v_h$ is a crystal growth rate higher than the mean pulling speed and $v_n$ is a crystal growth rate lower than the mean pulling speed, and the crystal growth during the ribbon-pulling operation changes periodically between a low rate $v_n$ and a high rate $v_h$ so that the total length of each p- and n-conductive zone in the crystallised silicon ribbon is from 5 to 2000 µm.

2. Process according to claim 1, characterised in that the dopant pairs selected are such as to allow a high average pulling speed with a small difference between $v_n$ and $v_h$.

3. Process according to claims 1 and 2, characterised in that indium/phosphorus, gallium/phosphorus or aluminium/arsenic are used as dopant pairs.

4. Process according to one or more of claims 1 to 3, characterised in that the periodic change from a low growth rate $v_n$ to a high growth rate $v_h$ is brought about by a periodic change in the pulling speed.

5. Process according to one or more of claims 1 to 3, characterised in that the periodic change from a low growth rate $(v_n)$ to a high growth rate $(v_h)$ is brought about by a periodic change in the temperature of the melt in the region of the growth front.

6. Process according to one or more of claims 1 to 5, characterised in that the total length 1 of each p- and n-conductive zone in the crystallised silicon is so related to the diffusion length $L_d$ of the minority charge carries in silicon for solar cells as to satisfy the condition

$$0.05 \, L_d < 1 < 2 \, L_d.$$

7. Use of the product of a process according to claim 6 as the basic material for solar cells.

## Revendications

1. Procédé de préparation de jonctions P-N verticales lors du tirage de rubans de silicium à partir d'un bain de silicium, caractérisé en ce que l'on ajoute au bain de silicium tant des dopants agissant comme accepteurs que des dopants aigssant comme donneurs dans le cristal de silicium, dont les coefficients de répartition efficaces $v_h$ à une vitesse élevée de croissance cristalline $v_h k_{Aeff}(v_n)$ et $k_{Deff}(v_n)$, de même que les coefficients de répartition effectifs $k_{Aeff}(v_n)$ et $k_{Deff}(v_n)$ correspondant à une faible vitesse de croissance cristalline $v_n$, doivent satisfaire à la condition suivante:

$$\frac{k_{Aeff}(v_n) \cdot k_{Deff}(v_h)}{k_{Aeff}(v_h) \cdot k_{Deff}(v_n)} > 3 \text{ ou } < 0.3$$

où on maintient une vitesse moyenne de tirage $(v_m)$ de 6 à 120 mm/min, et où, d'une manière

générale, $v_h$ est une vitesse de croissance cristalline supérieure à la vitesse moyenne de tirage et $v_n$ est une vitesse de croissance cristalline inférieure à la vitesse moyenne de tirage, la croissance cristalline, pendant le tirage du ruban, étant soumise à des variations périodiques, de la faible vitesse $v_n$ à la vitesse élevée $v_h$, de façon qu'il en résulte dans le ruban de silicium, après cristallisation, une longueur totale, tant de la zone conductrice de type P que la zone conductrice de type N, de 5 à 2000 μm.

2. Procédé selon la revendication 1 caractérisé en ce qu'on choisit en tant que paire de dopants une paire qui autorise une vitesse moyenne de tirage élevée, pour une faible différence entre $v_n$ et $v_h$.

3. Procédé selon les revendications 1 et 2, caractérisé en ce qu'on utilise en tant que paire de dopants les paires indium/phosphore, gallium/phosphore ou aluminium/arsenic.

4. Procédé selon l'une ou plusieurs des revendications 1 à 3, caractérisé en ce que la variation périodique de la vitesse de croissance, d'une vitesse faible $v_n$ à une vitesse élevée $v_h$, est ajustée par une variation périodique de la vitesse de tirage.

5. Procédé selon l'une ou plusieurs des revendications 1 à 3, caractérisé en ce que la variation périodique de la vitesse de croissance, de la faible vitesse ($v_n$) à la vitesse élevée ($v_h$), est ajustée par une variation périodique de la température du bain dans la zone du front de croissance.

6. Procédé selon l'une ou plusieurs des revendications 1 à 5, caractérisé en ce que la longueur totale 1, et de la zone conductrice de type P, et de la zone conductrice de type N, dans le silicium cristallisé, est ajustée en fonction de la distance de diffusion $L_d$ des porteurs minoritaires dans le silicium pour piles solaires, selon la condition:

$$0,05 \, L_d < 1 < 2 \, L_d$$

7. Utilisation du produit obtenu par le procédé selon la revendication 6, en tant que matière de base pour piles solaires.

0 055 372

Kristallwachstumsgeschwindigkeit v in mm / min

Fig. 1a

Dotierstoffkonzentration im Kristall C in cm$^{-3}$

Fig. 1b

Fig. 1

11

Kristallwachstumsgeschwindigkeit  v  in mm / min

Zeit t in s

**Fig. 2a**

Dotierstoffkonzentration im Kristall C in cm$^{-3}$

Zeit t in s

**Fig. 2b**

**Fig. 2**

0 055 372

Kristallwachstumsgeschwindigkeit v in mm / min

**Fig. 3a**

Dotierstoffkonzentration im Kristall C in cm$^{-3}$

**Fig. 3**

**Fig. 3b**

15

Fig. 4.

Fig. 5

Fig. 6

Fig. 7

Fig. 8

_Fig. 9_

_Fig. 10_

*Fig. 11*

6

26    28

27

22

3

2    1

*Fig. 12*

6

26

2

28

1

3

27

Fig. 13

Fig. 14

Fig. 15

Fig. 16

**Fig. 17**

**Fig. 18**